Europäisches Patentamt

European Patent Office

Office européen des brevets

(11) Veröffentlichungsnummer: **0 379 624**
**A1**

(12) **EUROPÄISCHE PATENTANMELDUNG**

(21) Anmeldenummer: 89101433.4

(51) Int. Cl.5: **H01L 23/495**

(22) Anmeldetag: 27.01.89

(43) Veröffentlichungstag der Anmeldung:
01.08.90 Patentblatt 90/31

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Maiwald, Werner**
**Am Kreuth 3**
**D-8202 Bad Aibling(DE)**

(54) **Anordnung eines zur Oberflächenmontage geeigneten Halbleiterbauelementes und ein Verfahren zu dessen Oberflächenmontage auf Trägerplatten.**

(57) Die Erfindung betrifft eine Anordnung eines zur Oberflächenmontage geeigneten Halbleiterbauelementes (1) und ein Verfahren zu dessen Oberflächenmontage auf Trägerplatten. Kennzeichnend für die neue Anordnung ist die ausschließliche Halterung der Anschlußbändchen (3) durch ein in der Anordnung vorhandenes Halbleiterchip (2) selbst, so daß der bisher übliche Kapton-Rahmen entfallen kann. Zusätzlich sind die duktilen Anschlußbändchen (3) um 90° zu einer Hauptfläche (4) des Halbleiterchips (2) abgewinkelt, so daß dadurch insgesamt eine im Vergleich zu den bisher üblichen TAB-Versionen wesentlich kleinere Bauweise und damit eine höhere Packungsdichte möglich ist. Zur Oberflächenmontage dieser neuen Anordnung (1) wird das Halbleiterchip (2) auf die Trägerplatte (7) aufgesetzt, wodurch sich die duktilen Anschlußbändchen (3) verformen und eine sichere Kontaktierung mit den auf der Trägerplatte angeordneten Anschlußflächen gewährleistet ist. Die Oberflächenmontage ist mit herkömmlichen SMD-Anlagen möglich.

**FIG 4**

## Anordnung eines zur Oberflächenmontage geeigneten Halbleiterbauelementes und ein Verfahren zu dessen Oberflächenmontage auf Trägerplatten

Die Erfindung betrifft eine Anordnung eines zur Oberflächenmontage geeigneten Halbleiterbauelementes nach dem Oberbegriff des Anspruchs 1 und ein Verfahren zu dessen Oberflächenmontage auf Trägerplatten.

Bauelemente in sogenannter TAB-Version (Tape Automated Bonding) als SMD-Bauelemente sind allgemein bekannt und z. B. in Siemens Components 26, 1988, Heft 3 auf den Seiten 105 bis 109 beschrieben.

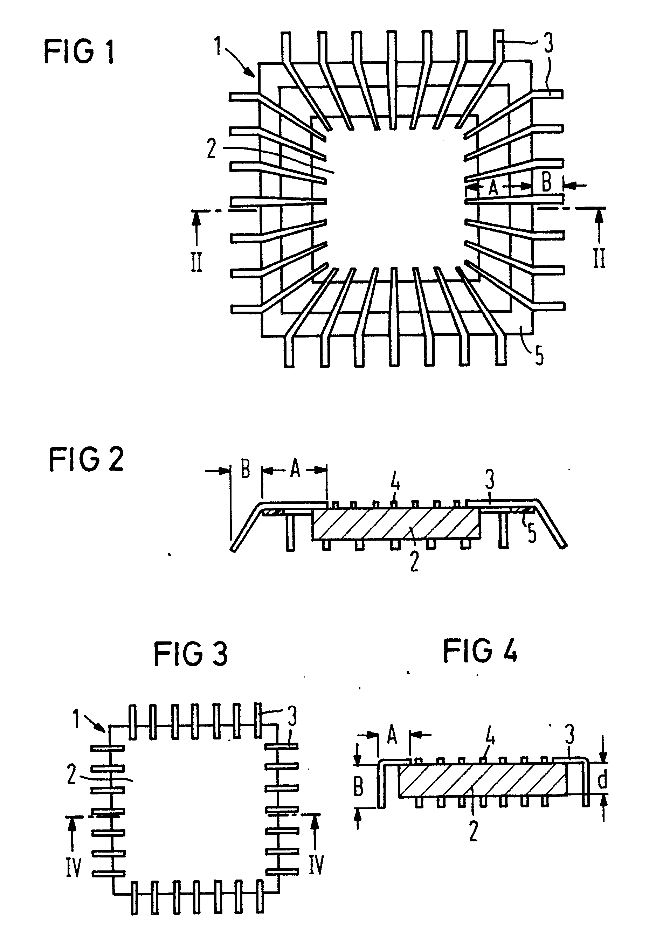

In den vorliegenden FIG 1 und 2 ist eine solche TAB-Anordnung dargestellt. Es besteht im wesentlichen aus einem Halbleiterchip 2 und einer Vielzahl damit in Verbindung stehender und zunächst von einer Hauptfläche 4 des Halbleiterchips 2 in einem ersten Abschnitt A planparallel wegführender duktiler Anschlußbändchen 3. Gehaltert werden diese Anschlußbändchen 3 im wesentlichen von einem Kaptonrahmen 5, der zur mechanischen Stabilität der dünnen und im allgemeinen aus hochreinem Kupfer bestehenden Anschlußbändchen 3 beiträgt. Zum Bestücken von Trägerplatten mit dieser Anordnung saugt ein automatisch abholbarer Adapter die Anordnung am Kaptonrahmen an, wobei es gleichzeitig aus einer Vorratsrolle herausgestanzt und außerdem die Anschlußbändchen um etwa 45° zur Hauptfläche des Halbleiterchips abgebogen werden, wie dies auch in der Schnittdarstellung von FIG 2 an den zweiten Abschnitten B der Anschlußbändchen 3 deutlich zu sehen ist. Beim Platzieren der Anordnung 1 wird der Kaptonrahmen etwa 0,1 mm über der Trägerplatte abgesetzt. Die Anschlußbändchen 3 werden dabei zwangsweise in die vorher auf Anschlußflächen der Trägerplatte aufgebrachte Lotpaste getaucht und bis auf die Anschlußfläche der Trägerplatte gedrückt. Unebenheiten der Anschlußflächen auf der Leiterplatte werden durch Verbiegen der sehr duktilen Anschlußbändchen 3 ausgeglichen. So wird erreicht, daß wirklich jedes Anschlußbändchen 3 von Lotpaste umgeben ist.

Dieser Kaptonrahmen 5 zur Halterung der Anschlußbändchen 3, die im allgemeinen vom Halbleiterchip 2 auffächernd wegführen, um einen größeren Kontaktabstand der Anschlußbändchen 3 auf den Anschlußflächen der Trägerplatte zu gewährleisten, ist jedoch insofern problematisch, als es auf Rollen verarbeitet wird und durch die unterschiedlichen Materialien Kupfer und Kapton eine Art unerwünschter Bimetalleffekt entsteht. Die Kaptonfolie kann gewölbt sein, das dazu führt, daß die Anschlußbändchen 3 nicht in einer Ebene liegen und damit zu Fehlern in der Kontaktierung der Anordnung führt. Auch der durch den Kaptonrahmen 5 unvermeidbar größere Platzbedarf der Anordnung steht einer hohen Packungsdichte dieser Bauelementeform entgegen.

Der Erfindung liegt deshalb die Aufgabe zugrunde, diese bekannte Anordnung derart zu verändern, daß der Kaptonrahmen entbehrlich, eine hohe Packungsdichte gewährleistet und ein zuverlässiges Kontaktieren auf der Trägerplatte möglich ist sowie ein Verfahren zur Oberflächenmontage dieser neuen Anordnung anzugeben.

Gelöst wird diese Aufgabe für die Anordnung durch die kennzeichnenden Merkmale des Anspruchs 1 und für das erfindungsgemäße Verfahren durch die Merkmale des Anspruchs 10.

Weiterbildungen der Erfindung sind Gegenstand der Unteransprüche.

Der wesentliche Vorteil der erfindungsgemäßen Anordnung liegt in der insgesamt kleineren Abmessung der neuen Anordnung. Einer wesentlichen Forderung der SMD-Technologie an die SMD-Bauelemente, die möglichst klein, flach, leicht und auf den üblichen SMD-Fertigungsanlagen verarbeitbar sein sollen, wird mit dieser neuen Anordnung verbessert Rechnung getragen. Mit dieser neuen Anordnung ist eine Flächenreduzierung um über 50 % gegenuber der bisher bekannten TAB-Versionen mit Kaptonrahmen möglich. Da TAB-Anordnungen bevorzugt in Geräten verwendet werden, in denen es auf kleinsten Platzbedarf, geringstes Gewicht oder niedrigste Bauhöhe ankommt, wird durch die erfindungsgemäße Anordnung der bisher bekannte Stand wesentlich verbessert.

Die Erfindung wird im folgenden anhand von weiteren vier Figuren näher erläutert. Es zeigen:

FIG 1 Draufsicht auf eine bisher bekannte TAB-Anordnung,

FIG 2 Schnittdarstellung zu FIG 1,

FIG 3 eine erfindungsgemäße Anordnung in Draufsicht,

FIG 4 eine Schnittdarstellung zu FIG 3,

FIG 5 einen Ausschnitt einer neuen Anordnung mit Anschlußbändchen unterschiedlicher Länge, und

FIG 6 eine erfindungsgemäße Anordnung auf einer Trägerplatte mit Anschlußflächen.

In FIG 3 ist die Draufsicht auf eine erfindungsgemäße Anordnung eines zur Oberflächenmontage geeigneten Halbleiterbauelementes dargestellt. Dieses Halbleiterbauelement besteht aus mindestens einem Halbleiterchip 2 und einer Vielzahl damit in Verbindung stehender und zunächst von einer Hauptfläche 4 des Halbleiterchips 2 wie bei dem bekannten Stand der Technik in einem ersten Abschnitt A planparallel wegführender duktiler Anschlußbändchen 3. Im Gegensatz zum bekannten Stand der Technik (vgl. FIG 1 und FIG 2) werden die Anschlußbandchen 3 ausschließlich vom Halbleiterchip 2 selbst gehalten. Zweckmäßigerweise enthält dazu das Halbleiterchip 2 auf seinen bevorzugt aus Aluminium gebildeten Anschlußkontakten, die normalerweise für die Drahtmontage vorgesehen sind, massive Metallhöcker, auf die die Anschlußbändchen 3, die sog. Kupferspinne, auflötbar ist. Diese Kupferspinne wird im allgemeinen aus etwa 35 μm dicken ganzflächig kaschierten Kupferfolien fotochemisch hergestellt und auf diese Metallhöcker simultan mittels eines Lötstempels aufgelötet. Das Halbleiterchip 2 wird komplett mit einer z. B. Plasmanitritschicht abgedeckt, und zwar überlappend bis unter die Metallhöcker, damit das Aluminium vollständig vor Korrosion geschützt wird. Als Schutz vor mechanischer Beschädigung und als Angriffsfläche für Bestückungsautomaten wird der Chip auf der Oberseite z. B. mit einer Platte aus Epoxyd abgedeckt. Eine weitere Halterung für die Anschlußbändchen 3 ist nicht vorgesehen.

Wie aus der Schnittdarstellung der erfindungsgemäßen Anordnung in FIG 4 ersichtlich ist, sind die Anschlußbändchen 3 mindestens annähernd um einen Winkel von 90° zur Hauptfläche 4 des Halbleiterchips 2 abgebogen, so daß ein zweiter zum Halbleiterchip 2 senkrechter Abschnitt B der Anschlußbändchen 3 eine Länge aufweist, die größer als die Dicke d des Halbleiterchips 2 ist. Durch diese erfindungsgemäße Anordnung wird erreicht, daß die Anordnung wesentlich in seinen Abmessungen reduziert ist. Eine größere Packungsdichte ist die Folge. Im Vergleich zum bisherigen Stand der Technik können die Anschlußbändchen 3 insgesamt auch kürzer ausgeführt werden, wie die Figuren 2 und 4 deutlich zeigen. Besonders vorteilhaft werden die Anschlußbändchen 3 aus hochreinem Kupfer gebildet, um so die Anschlußbändchen 3 leicht verformbar zu halten. Eine Verfestigung der Steifigkeit der Anschlußbändchen 3 wird durch Beimengung von 1 bis 2 Eisen erreicht.

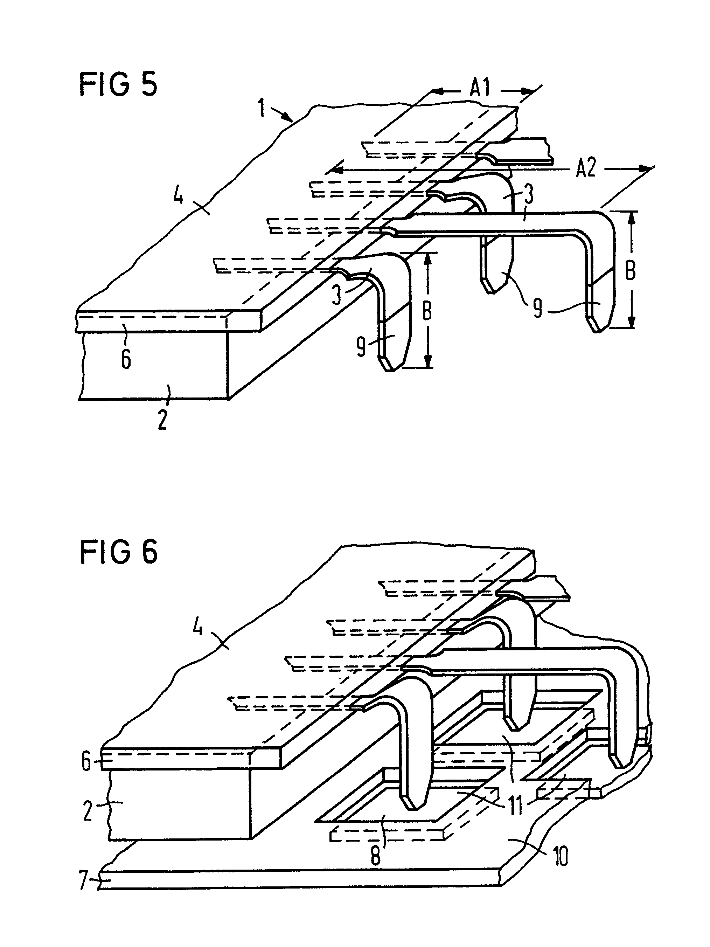

In FIG 5 ist eine bevorzugte Weiterbildung der erfindungsgemäßen Anordnung eines zur Oberflächenmontage geeigneten ausgebildeten Halbleiterbauelementes 1 perspektivisch in einem Ausschnitt dargestellt. Zwei unmittelbar benachbarte Anschlußbändchen 3 weisen jetzt eine unterschiedliche Länge ihrer ersten zur Hauptfläche 4 des Halbleiterchips 2 planparallel wegfüh render Abschnitte A1, A2 auf. Durch diese unterschiedlichen Längen der Anschlußbändchen 3 kann in einfacher Weise erreicht werden, daß die Anschlußflächen auf einer Trägerplatte, auf die die Anordnung 1 oberflächenmontiert werden soll, zueinander einen größeren Abstand aufweisen können und damit bei gleicher Leiterplattentechnik eine Halbierung des Anschlußrasters der Anordnung 1 möglich ist. Weiterhin ist es möglich, die freien Enden der Anschlußbändchen 3 spitzförmig auszugestalten, um die Anschlußbändchen 3 leichter in die Lötpaste, die auf den Anschlußflächen der Trägerplatte aufgebracht ist, einzuführen. Zur Erreichung einer besseren Lötbarkeit sind die freien Enden der Anschlußbändchen 3 mit einer lötbaren Oberflächenschicht 9 versehen.

Als besonders vorteilhaft hat es sich herausgestellt, Sollbiegestellen an den Anschlußbändchen 3 vorzusehen, die geeignet sind beim Ausüben von Druck senkrecht zur Hauptfläche 4 des Halbleiterchips 2 auf die freien Enden der abgebogenen Abschnitte B der Anschlußbändchen 3 bevorzugt zu verformen. Damit kann beim Aufsetzen auf eine Trägerplatte ein sicherer Kontakt der Anschlußbändchen 3 zu den Anschlußflächen der Trägerplatte erzielt werden. So hat es sich als günstig herausgestellt, den Querschnitt der Anschlußbändchen 3 im ersten Abschnitt, hier also A1 und A2, mindestens teilweise kleiner zu wählen als im zweiten senkrechten Abschnitt B. Dadurch bleibt der senkrechte Abschnitt B bei Druckausübung auf die freien Enden der Anschlußbändchen 3 im wesentlichen unverformt, während die Verformung am Übergang vom größeren zum kleinen Querschnitt des Anschlußbändchen 3 einsetzt. Unterstützt kann diese Tendenz dadurch werden, daß auf dem Halbleiterchip 2 eine Abdeckplatte 6, bevorzugt aus Kunststoff, wie z. B. Epoxyd, aufgesetzt ist, die das Halbleiterchip 2 überlappt, und zwar soweit, daß gerade der zweite Abschnitt B der kürzeren Anschlußbändchen 3 nicht mehr überdeckt wird. Diese Abdeckplatte 6 dient so mindestens teilweise zur Stützung und gegebenenfalls der Halterung der ersten Abschnitte A1, A2 der Anschlußbändchen 3.

Das erfindungsgemäße Verfahren zur Oberflächenmontage dieser erfindungsgemäßen Anordnung auf einer mit einer Vielzahl von Anschlußflächen versehenen Trägerplatte ist durch folgende Verfahrensschritte gekennzeichnet:
- Mechanisches Erfassen der Anordnung,
- Ausrichten der Anschußbändchen zu den Anschlußflächen der Trägerplatte,
- Aufsetzen und Fixieren der Anordnung auf die Trägerplatte mit mindestens teilweiser Verformung der duktilen Anschlußbändchen und dadurch entstehendes Kontaktieren der Anschlußbändchen mit den Anschlußflächen der Trägerplatte, und
- Verlöten der Anschlußbändchen mit den Anschlußflächen.

Eine auf eine Trägerplatte 7 oberflächenmontierte Anordnung 1 nach dem Verfahren ist in FIG 6 dargestellt. Mit dem Bezugszeichen 8 sind die Anschlußflächen der Trägerplatte gekennzeichnet. Der besseren Übersichtlichkeit wegen ist die auf die Anschlußflächen 8 gegebenenfalls vor dem Aufsetzen der Anordnung 1 auf die Trägerplatte 7 aufgebrachte Lötpaste nicht dargestellt.

Fixierbar ist die erfindungsgemäße Anordnung 1 nach dem erfindungsgemäßen Verfahren auf der Trägerplatte 7 entweder durch die Lötpaste auf den Anschlußflächen 8 der Trägerplatte 7 oder durch Aufkleben oder Auflöten des Halbleiterchips 2. Das Aufkleben kann mit einem elektrisch leitenden Klebemittel erfolgen, wenn z. B. eine Kontaktierung des Halbleiterchips selbst notwendig ist.

Bisher wurde das erfindungsgemäße Verfahren anhand der Tatsache dargestellt, daß das Halbleiterchip 2 direkt äuf Anschlag auf die Trägerplatte 7 aufgesetzt wird, wobei sich die Anschlußbändchen 3 verbiegen, so daß auf alle Fälle ein mechanischer Kontakt zur Anschlußfläche 8 besteht. Bei entsprechend langer Ausführung dieser Anschlußbändchen 3 und dort insbesondere der senkrechten zweiten Abschnitte B, ist es auch möglich, zwischen die Trägerplatte 7 und das Halbleiterchip 2 eine Abstandshalteeinrichtung anzuordnen. Ist dies der Fall, wird das Halbleiterchip 2 auf Anschlag auf diese Abstandshalteeinrichtung aufgesetzt. Voraussetzung ist, daß sich die Anschlußbändchen 3 an der obengenannten Sollbiegestelle verformen können.

Wie anhand von FIG 6 dargestellt, ist es auch möglich, zwischen die Trägerplatte 7 und das Halbleiterchip 2 eine Folie 10, z. B. eine 100 μm dicke Trockenfilm-Lötstoppmaske, anzuordnen, die an den Anschlußflächen 8 der Trägerplatte 7 Öffnungen aufweist, die zur Führung der Anschlußbändchen 3 an die Anschlußflächen 8 der Trägerplatte 7 dienen. Dazu weist diese Folie 10 auf den Anschlußflächen Öffnungen 11 auf. Unter Ausnutzung der dadurch erreichbaren Führungsfunktion dieser Öffnungen 11 können die Anschlußbädchen 3 in einfacher Weise auf der Trägerplatte 7 fixiert werden.

**Ansprüche**

1. Anordnung-eines zur Oberflächenmontage geeigneten Halbleiterbauelementes (1), bestehend aus mindestens einem Halbleiterchip (2) und einer Vielzahl damit in Verbindung stehender und zunächst von einer Hauptfläche (4) des Halbleiterchips (2) in einem ersten Abschnitt (A) planparallel wegführender duktiler Anschlußbändchen (3), **dadurch gekennzeichnet,** daß die Anschlußbändchen (3) vom Halbleiterchip (2) gehalten sind, und daß die Anschlußbändchen (3) um mindestens annähernd einen Winkel von 90° zur Hauptfläche (4) des Halbleiterchips (2) abgebogen sind, so daß ein zweiter zum Halbleiterchip (2) senkrechter Abschnitt (B) der Anschlußbändchen (3) eine Länge aufweist, die größer als die senkrecht zur Hauptfläche des Halbleiterchips (2) vorhandene Dicke (d) ist.

2. Anordnung nach Anspruch 1, **dadurch gekennzeichnet,** daß die Anschlußbändchen (3) an ihren Enden im senkrechten zweiten Abschnitt (B) spitzenförmig ausgebildet sind.

3. Anordnung nach Anspruch 1 oder 2, **dadurch gekennzeichnet,** daß die Anschlußbändchen (3) mindestens an ihren Enden im senkrechten zweiten Abschnitt (B) mit einer lötbaren Oberflächenschicht (9) versehen sind.

4. Anordnung nach einem der Ansprüche 1 bis 3, **dadurch gekennzeichnet,** daß die Anschlußbändchen (3) aus Kupfer gebildet sind.

5. Anordnung nach Anspruch 4, **dadurch gekennzeichnet,** daß die Anschlußbändchen (3) aus Kupfer mit einem Anteil von 1 % bis 2 % Eisen gebildet sind.

6. Anordnung nach einem der Ansprüche 1 bis 5, **dadurch gekennzeichnet,** daß zwei unmittelbar benachbarte Anschlußbändchen (3) unterschiedliche Längen in ihren ersten zur Hauptfläche (4) des Halbleiterchips (2) planparallel wegführenden Abschnitten (A1, A2) aufweisen.

7. Anordnung nach einem der Ansprüche 1 bis 6, **dadurch gekennzeichnet,** daß die Anschlußbändchen (3) Sollbiegestellen aufweisen, die geeignet sind, beim Ausüben von Druck senkrecht zur Hauptfläche (4) des Halbleiterchips (2) auf die freien Enden der Anschlußbändchen (3), bevorzugt zu verbiegen.

8. Anordnung nach einem der Ansprüche 1 bis 7, **dadurch gekennzeichnet,** daß die ersten Abschnitte (A, A1, A2) der Anschlußbändchen (3) mindestens teilweise einen kleineren Querschnitt als im zweiten Abschnitt (B) aufweisen.

9. Anordnung nach einem der Ansprüche 1 bis 8, **dadurch gekennzeichnet,** daß auf der Hauptfläche (4) des Halbleiterchips (2) eine die Hauptfläche (4) überlappende und zur mindestens teilweisen Stützung der ersten Abschnitte (A1, A2) der Anschlußbändchen (3) dienende Abdeckplatte (6) aufgebracht ist.

10. Verfahren zur Oberflächenmontage der Anordnung nach einem der Ansprüche 1 bis 9 auf einer mit Anschlußflächen (8) versehenen Trägerplatte (7), **gekennzeichnet** durch folgende Verfahrensschritte:
- mechanisches Erfassen der Anordnung (1),
- Ausrichten der Anschlußbändchen (3) zu den Anschlußflächen (8) der Trägerplatte (7),

- Aufsetzen und Fixieren der Anordnung (1) auf die Trägerplatte (7) mit mindestens teilweiser Verformung der duktilen Anschlußbändchen (3) und dadurch entstehender Kontaktierung der Anschlußbändchen (3) mit den Anschlußflächen (8), und

- Verlöten der Anschlußbändchen (3) mit den Anschlußflächen (8).

11. Verfahren nach Anspruch 10,

**dadurch gekennzeichnet,**

daß die Anschlußflächen (3) bereits vor dem Aufsetzen der Anordnung (1) mit Lötpaste versehen werden.

12. Verfahren nach einem der Ansprüche 10 oder 11,

**dadurch gekennzeichnet,**

daß die Trägerplatte (7) mit einer Öffnung (11) an den Anschlußflächen (8) aufweisenden Folie (9) abgedeckt wird und das Aufsetzen und Fixieren der Anordnung (1) unter Ausnutzung der dadurch erreichbaren Führungsfunktion dieser Öffnungen (11) für die Anschlußbändchen (3) erfolgt.

13. Verfahren nach einem der Ansprüche 10 bis 12,

**dadurch gekennzeichnet,**

daß das Halbleiterchip (2) auf die Trägerplatte (7) durch die Verwendung eines elektrisch leitenden oder nicht leitenden Klebemittels aufgeklebt wird.

14. Verfahren nach einem der Ansprüche 10 bis 12,

**dadurch gekennzeichnet,**

daß das Halbleiterchip (2) auf die Trägerplatte (7) aufgelötet wird.

15. Verfahren nach einem der Ansprüche 10 bis 14,

**dadurch gekennzeichnet,**

daß mindestens im Zentrum der Anschlußflächen (8) der Trägerplatte (7) eine Abstandshalterung aufgebracht wird und das Aufsetzen der Anordnung (1) auf die Abstandshalteeinrichtung erfolgt.

FIG 1

FIG 2

FIG 3

FIG 4

**FIG 5**

**FIG 6**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 495 839 (GAO)<br>* Figur 10; Anspruch 1 *<br>--- | 1 | H 01 L 23/495 |
| A | PATENT ABSTRACTS OF JAPAN, Band 12, Nr. 9 (E-572)[2856], 12. Januar 1988; & JP-A-62 169 354 (HITACHI LTD) 25-07-1987<br>--- | 1-3,10 | |
| A | GB-A-2 103 418 (BRACEY)<br>* Figur 9; Seite 1, Zeilen 12-14 *<br>--- | 1,4 | |
| A | PATENT ABSTRACTS OF JAPAN, Band 12, Nr. 3 (E-570)[2850], 7. Januar 1988; & JP-A-62 163 352 (TOSHIBA CORP.) 20-07-1987<br>--- | 2,7 | |
| A | EP-A-0 077 276 (FAIRCHILD)<br>* Figur 2; Anspruch 1 *<br>--- | 8 | |
| D,A | SIEMENS COMPONENTS, Band 23, Nr. 3, 1988, Seiten 105-109, München, DE; W. MAIWALD: "Mikropack - Third generation SMDs"<br>* Figuren 7,8 *<br>----- | 10 | **RECHERCHIERTE SACHGEBIETE (Int. Cl.5)**<br><br>H 01 L |

Der vorliegende Recherchenbericht wurde für alle Patentansprüche erstellt

| Recherchenort | Abschlußdatum der Recherche | Prüfer |
|---|---|---|
| DEN HAAG | 14-09-1989 | DE RAEVE R.A.L. |